# EUROPEAN PATENT APPLICATION

(11) **EP 2 239 604 A1**
(43) Date of publication of application: **13.10.2010**
(21) Application number: 08871802.8
(22) Date of filing: 09.10.2008
(51) Int. Cl.: G02B 6/122, H05K 1/02

(54) **OPTO-ELECTRIC HYBRID BOARD AND ELECTRONIC DEVICE**

(30) Priority: 01.02.2008 JP 2008023116
(71) Applicant: Hitachi Chemical Company, Ltd., Tokyo 163-0449 (JP)
(72) Inventor: KURODA, Toshihiro, Tsukuba-shi Ibaraki 300-4247 (JP); SHIBATA, Tomoaki, Tsukuba-shi Ibaraki 300-4247 (JP); YAGI, Shigeyuki, Tsukuba-shi Ibaraki 300-4247 (JP)
(74) Representative: HOFFMANN EITLE
(86) International application number: PCT/JP2008/068364
(87) International publication number: WO 2009/096067

(57) **Abstract**

A flexible opto-electric hybrid board containing an optical waveguide film containing a core and a clad, and a flexible electric circuit board bonded to each other, the flexible opto-electric circuit board further having a reinforcing member disposed on at least a part on a side of the optical waveguide film to be bent, and an electronic device containing the flexible opto-electric hybrid board.

Such an opto-electric hybrid board having an optical waveguide film and a flexible electric circuit board bonded to each other is provided that does not suffer breakage or cracks even when the circuit board is bent or folded, and an electronic device containing the opto-electric hybrid board is also provided.

## Description

### BACKGROUND OF THE INVENTION

The present invention relates to an opto-electric hybrid board with flexibility having optical wiring and electrical wiring combined, and an electronic device containing the circuit board.

### RELATED ART

In recent years, the high-speed and high-density signal transmission among electronic devices and among circuit boards is encountering limitation in increase of the speed and density thereof due to barriers in transmission through conventional electric wiring, i.e., mutual interference and attenuation of signals. In order to break the limitation, a technique for connecting electronic devices and circuit boards by means of light, i.e., so-called optical interconnection, is being investigated. A polymer optical waveguide receives attention as an optical transmission path owing to easiness in processing, low cost, and high freedom and high density in wiring.
In particular, the use of an optical waveguide in a mobile phone, a notebook computer and the like is investigated, and an opto-electric hybrid board having optical wiring and electric wiring combined receives attention for space saving and reduction in thickness (see, for example, Patent Document 1, Fig. 2).

In an electronic device, such as a mobile phone, which is one of the application fields of an opt-electric hybrid board, it is assumed to use a flexible opto-electric hybrid board for signal transmission between two openable and closable mechanical units, and it is considered that the flexible opto-electric hybrid board bridges the two mechanical units through a connecting part (hinge). The flexible opto-electric hybrid board is generally bent to make the flexible electric circuit board into contact with the hinge, and the optical waveguide part may suffer breakage and cracks by bending in some cases. In particular, the circuit board is required to be bent at the hinge in a small bending radius R of from 1.5 to 2 mm associated with demand of reduction in size of electronic devices in recent years, thereby causing a problem in notable occurrence of breakage and cracks at the hinge.

In order to solve the problem, such a flexible opto-electric circuit board has been proposed that an optical waveguide film and a flexible electric circuit board are partly bonded to each other, and are not bonded to each other at least a part where the circuit board is bent (see, Patent Document 2, scope of claim).
Even in the aforementioned techniques, however, the optical waveguide part receives stress when the circuit board is actually bent at the hinge, thereby failing to solve the problem in occurrence of breakage and cracks.

Patent Document 1: Japanese Patent No. 3193500
Patent Document 2: Japanese Paten Application Laid-Open No. 284925/2006

### DISCLOSURE OF THE INVENTION

The present invention has been made for solving the aforementioned problems, and an object thereof is to provide such an opto-electric hybrid board having an optical waveguide film and a flexible electric circuit board bonded to each other that does not suffer breakage or cracks even when the circuit board is bent or folded, and to provide an electronic device containing the opto-electric hybrid board.

As a result of earnest investigations made by the present inventors, it has been found that an opto-electric hybrid board can be significantly enhanced in strength by disposing a reinforcing member in a position that receives stress upon bending at a hinge, thereby preventing breakage and cracks from occurring in the optical waveguide part. The present invention has been completed based on the finding.
Accordingly, the present invention provides a flexible opto-electric hybrid board comprising an optical waveguide film containing a core and a clad, and a flexible electric circuit board bonded to each other, the flexible opto-electric circuit board further having a reinforcing member disposed on at least a part on a side of the optical waveguide film to be bent, and also provides an electronic device containing the flexible opto-electric hybrid board.

The opto-electric hybrid board and the electronic devices containing the opto-electric hybrid board according to the present invention have such a good bending durability that the opto-electric hybrid board does not suffer breakage and cracking even after suffering repeated bending over a prolonged period of time and maintains good communication function.

### BRIEF EXPLANATION OF THE DRAWINGS

Fig. 1 is a conceptual illustration showing an example of a flexible opto-electric hybrid board according to the present invention.
Fig. 2 is a conceptual illustration of the flexible opto-electric hybrid board according to the present invention shown in Fig. 1 in a bent state.
Fig. 3 is an enlarged illustration of a hinge part in Fig. 2.
Fig. 4 is a conceptual illustration showing another example of a flexible opto-electric hybrid board according to the present invention.
Fig. 5 is a conceptual illustration of the flexible opto-electric hybrid board according to the present invention shown in Fig. 4 in a bent state.
Fig. 6 is a conceptual illustration showing an example of a flexible opto-electric hybrid board in the case where an electronic device has a sliding mechanism.

### EXPLANATION OF CODES

1. Flexible opto-electric hybrid board
2. Flexible electric circuit board
3. Optical waveguide film
4. Hinge
5. Reinforcing member
6. Bent part
7. Bending shaft

### BEST MODE FOR CARRYING OUT THE INVENTION

The opto-electric hybrid board of the present invention contains an optical waveguide containing a core and a clad, and a flexible electric circuit board bonded to each other, and a reinforcing member is disposed on at least a part on a side of the optical waveguide film to be bent. The present invention will be described in detail with reference to the drawings below.

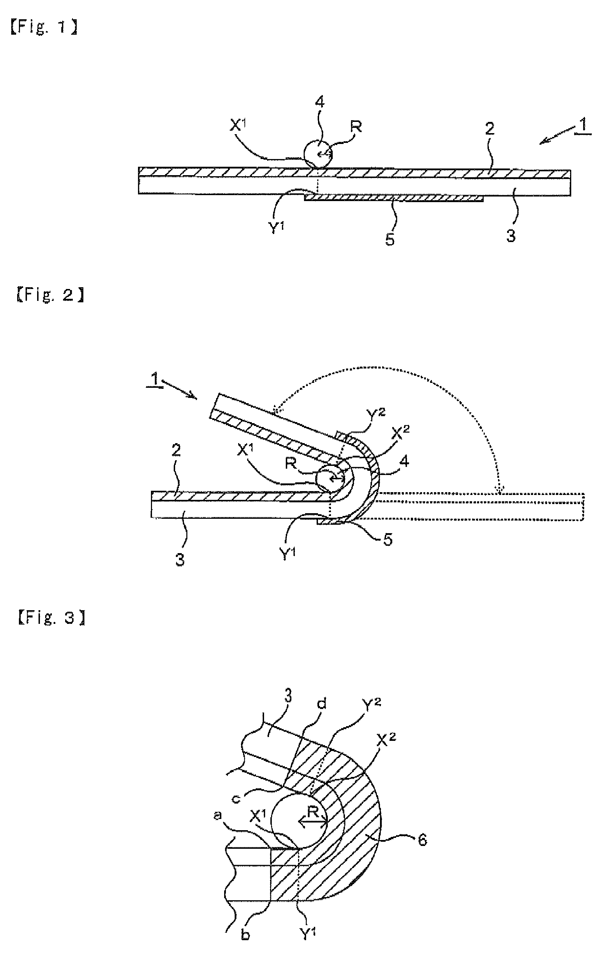

Figs. 1 to 6 are conceptual illustrations for describing the opto-electric hybrid board of the present invention. The opto-electric hybrid board 1 of the present invention has, as shown in Fig. 1, an optical waveguide film 3 having a core and a clad, and a flexible electric circuit board 2 bonded to each other, and a reinforcing member 5 is disposed on a part on the side of the optical waveguide film to be bent. Taking the adhesiveness between the optical waveguide film 3 and the flexible electric circuit board 2 into consideration, it is preferred that they are adhered over the entire surfaces.
The opto-electric hybrid board of the present invention is applied to an electronic device having such a structure that a part of the opto-electric hybrid board is movable in a rotation direction with a hinge 4 as center, as shown in Fig. 2.

One of the features of the opto-electric hybrid board of the present invention is, as described above, the reinforcing member 5 disposed on the part on the side of the optical waveguide film to be bent, and the part to be bent in the present invention (which will be referred to as a "bent part" hereinafter) includes a part that is in contact with a hinge and an outer peripheral part thereof in the state where the opto-electric hybrid board is bent. Specifically, as shown in Fig. 3, which is an enlarged illustration of the hinge part, the bent part includes a part surrounded by the bend starting point X¹ where the circuit board starts to be bent with the hinge in contact therewith, the bend ending point X² where the bending ends, and the points Y¹ and Y² on the side of the optical waveguide film corresponding to X¹ and X², respectively, and also includes a part 6 expanded outward therefrom, i.e., a part surrounded by the points a, b, c and d. The distance between points a and X¹ in the expanded part is not particularly limited within the range where the advantages of the present invention are obtained, and may be approximately from 1 to 10% of the distance between the points X¹ and X².
Accordingly, the position where the reinforcing member 5 is disposed in the present invention is on the side of the optical waveguide film of the bent part 6 surrounded by the points a, b, c and d of the opto-electric hybrid board 1, and the reinforcing member 5 provided at least at part of the region imports significantly high bending durability thereto.

More specifically, the optical waveguide film 3 disposed on the outer peripheral side in Fig. 3 receives the maximum value of the bending stress on the outermost peripheral side, i.e., on the surface of the optical waveguide film 3, and in order to reduce the bending radius R, it is necessary to reduce the elastic modulus of the waveguide for facilitating the bending operation. However, reduction of the elastic modulus generally decreases the tensile strength, and therefore, in the case where the bending radius R is small, the optical waveguide film suffers shortage of the strength on the surface thereof to cause cracks, which bring about breakage thereof.
In the present invention, it has been found that the reinforcing member 5 is disposed on the surface of the optical waveguide film where the bending stress becomes maximum, whereby the bending strength against the maximum stress occurred on the surface is shared by the reinforcing member, and thus cracks are prevented from occurring in the film waveguide having low elastic modulus even in the state where the bending radius R is small.
Furthermore, it has also been found that when the thickness of the reinforcing member 5 is increased, such a strength can be provided that resists the bending stress occurring inside within the thickness from the surface.

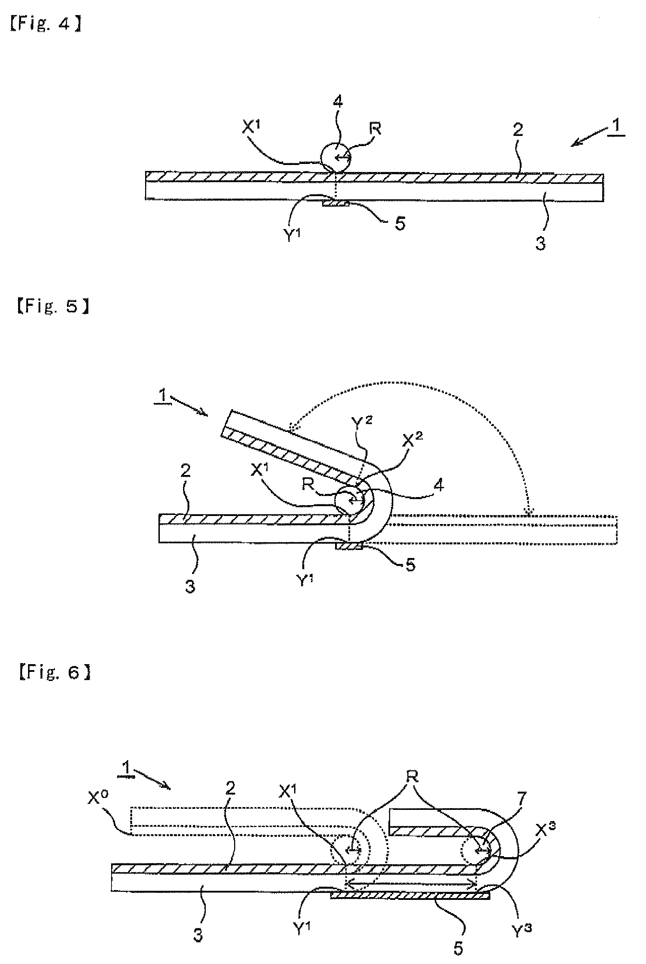

Figs. 1 and 2 show an example of the opto-electric hybrid board of the present invention, which is an example where the reinforcing member 5 is disposed on the side of the optical waveguide film of the opto-electric hybrid board over the entire bent part 6. In this manner, the reinforcing member 5 may be provided over the entire bent part 6 or may be provided on only a part thereof. In other words, the reinforcing number 5 may not be necessarily provided over the entire bent part unless the advantages of the present invention cannot be obtained.
In the bent part 6, the part on the side of the optical waveguide film Y¹ corresponding to the bend starting point X¹ is particularly preferably reinforced, and for example, as shown in Figs. 4 and 5, the reinforcing member 5 may be disposed only on a part covering the part Y¹, thereby imparting high bending durability.

Fig. 6 shows an example where an electronic device has a sliding mechanism. The opto-electric hybrid board 1 is bent with the bent part as center, and in this state, for example, the straight portions of the flexible opto-electric hybrid board disposed on the upper side and the lower side respectively arse substantially in parallel to each other, While maintaining the bent state, at least one end part X⁰ of the opto-electric hybrid board 1 is moved (in the rightward direction in Fig. 6), and the bent part is also moved associated with the movement of the end part. Accordingly, the bend starting point is moved associated with the movement of the end part X⁰. In this case, the range, within which the bend starting point is moved, is preferably reinforced with the reinforcing member 5. Specifically, as shown in Fig. 6, the part (Y¹ to Y³) on the side of the optical waveguide film within the range of from the move starting point (X¹) in the horizontal direction of the bent part 6 to the move ending point (X³) thereof is preferably reinforced.
In an electronic device having a sliding mechanism, in which the opto-electric hybrid board is bent, and a shaft 7 (which will be referred to as a "bending shaft" hereinafter) corresponding to the hinge 4 is assumed, as shown in Fig. 6, the bent part means a part that is in contact with the bending shaft and an outer peripheral part thereof, and thus the definition thereof is the same as the aforementioned description of the bent part provided that the hinge 4 is replaced by the bending shaft 7. The bending shaft may be actually provided, whereby the sliding mechanism is achieved by moving the bending shaft 7 in the horizontal direction with or without rotation. In alternative, the bending shaft 7 may not be actually provided, and the sliding structure is achieved by holding the opto-electric hybrid board 1 with lid members and the like from above and below, and moving the end part X⁰ of the opto-electric hybrid board 1 in the horizontal direction through the movement of the lid members. The opposite end of the opto-electric hybrid board is generally fixed, but may have such a structure that the opposite end is moved in the opposite direction to the end part X⁰.

The material used as the reinforcing member 5 is not particularly limited as far as the advantages of the present invention can be obtained, and a material having a tensile strength that is larger than that of the optical waveguide film is preferably used from the standpoint of effective exhibition of the bending durability. More specifically, the reinforcing member preferably has a tensile strength three times or more, more preferably a strength five times or more, and particularly preferably a strength eight times or more, greater than the tensile strength of the optical waveguide film. The tensile strength referred herein does not depend on the measurement method therefor, but what is important is the relative values between the reinforcing material and the optical waveguide film, and is generally measured according to JIS K7127.

Specific examples of the material used as the reinforcing member include a polyimide resin used as a substrate of a flexible electric circuit board, and also include an aramid resin, a glass fiber-reinforced resin and a carbon fiber-reinforced resin, and among these, a polyimide resin and an aramid resin are preferred from the standpoint of exhibition of the advantages of the present invention. These resins may be used solely or as a combination of two or more of them.

The thickness of the reinforcing member is not particularly limited within the range where the advantages of the present invention are exhibited, and the ratio to the thickness of the substrate constituting the flexible electric circuit board (reinforcing member/flexible electric circuit boared) is preferably in a range of from 4/1 to 1/4. The thickness of the reinforcing member is preferably relatively small for suppressing the optical loss, and the thickness of the reinforcing member is preferably relatively large for achieving the bending durability. In order to attain both factors, the ratio in thickness of the reinforcing member and the flexible electric circuit board is preferably in a range of from 1/1 to 1/4, and particularly preferably in a range of from 1/1 to 1/2.
In consideration of practical installation in an electronic device, the thickness of the reinforcing member is preferably in a range of from 4 to 50 µm, and for suppressing the optical loss, is more preferably in a range of from 4 to 25 µm, and particularly preferable in a range of from 4 to 15 µm.

The optical waveguide film and the flexible electric circuit board used in the present invention will be explained below.

### Optical Waveguide Film

The optical waveguide film of the present invention has a core and a clad, and those having been used as an optical waveguide film can be used. For example, a resin film for forming an optical waveguide formed of a resin composition containing (A) a base polymer, (B) a photopolymerizable compound and (C) a photopolymerization initiator can be used.

In the case where a cured product, such as a film, is to be formed, the base polymer (A) is used for ensuring strength of the cured product, and is not particularly limited as far as the object thereof is attained, and examples thereof include a phenoxy resin, an epoxy resin, a (meth)acrylic resin, a polycarbonate resin, a polyallylate resin, polyetheramide, polyetherimide, polyethersulfone and derivatives thereof. The base polymer may be used solely or as a mixture of two or more thereof.

The photopolymerizable compound (B) is not particularly limited as far as it is polymerized by irradiation with light, such as an ultraviolet ray, and is preferably a compound having an ethylenically unsaturated group in the molecule thereof from the standpoint of reactivity with light. Specific examples thereof include (meth)acrylate, vinylidene halide, vinyl ether, vinylpyridin and vinylphenol, and among these, (meth)acrylate is preferred from the standpoint of transparency and heat resistance. Any of a monofunctional compound, a bifunctional compound and a trifunctional compound can be used as the (meth)acrylate.
The term (meth)acrylate herein means acrylate and methacrylate.

The photopolymerization initiator (C) is not particularly limited, and examples thereof include an aromatic ketone, such as benzophenone, N.N'-tetramethyl-4,4'-diaminobenzophenone (Michler's ketone), N,N'-tetraethyl-4,4'-diaminobenzophenone, 4-methoxy-4'-dimethylaminobenzophenone, 2-benzyl-2-dimethylamino-1-(4-morpholinophenyl)-butan-1-one, 2,2-dimethoxy-1,2-diphenylethan-1-one, 1-hydroxycyclohexyl phenyl ketone, 2-hydroxy-2-methyl-1-phenylpropan-1-one, 1- (4- (2-hydroxyethoxy)phenyl)-2-hydroxy-2-methyl-1-propan-1-one and 1,2-methyl-1-(4- (methylthio)phenyl) -2-morpholinopropan-1-one; a quinone, such as 2-ethylanthraquinone, phenanthrenequinone, 2-tert-butylanthraquinone, octamethylanthraquinone, 1,2-benzanthraquinone, 2,3-benzanthraquinone, 2-phenylanthraquinome, 2,3-diphenylanthraquinone, 1-chloroanthraquinone, 2-methylanthraquinone, 1,4-naphthoquinone, 9,10-phenanthraquinone, 2-methyl-1,4-naphthoquinone and 2,3-dimethylanthraquinone; a benzoin ether compound, such as benzoin methyl ether, benzoin ethyl ether and benzoin phenol ether; a benzoin compound, such as benzoin, methylbenzoin and ethylbenzoin; a benzyl derivative, such as benzyl dimethyl ketal; a 2,4,5-triarylimidazole dimer, such as 2-(o-chlorophenyl)-4,5-diphenylimidazole dimer, 2-(o-chlorophenyl)-4,5-di(methoxyphenyl)imidazole dimer, 2-(o-fluorophenyl)-4-5-diphenylimidazole dimer, 2- (o-methoxyphenyl)-4,5-diphenylimidazole dimer and 2- (p-methoxyphenyl)-4,5-diphenylimidazole dimer; a phosphine oxide, such as bis(2,4,6-trimethylbenzoyl)phenylphosphine oxide, bis(2,6-dimethoxybenzoyl)-2,4,4-trimethylpentylphosphine oxide and 2,4,6-trimethylbenzoyldiphenylphosphine oxide; an acridine derivative, such as 9-phenylacridine and 1,7-bis(9,9'-acridinyl)heptane; N-phenylglycine; an N-phenylglycine derivative; and a coumarin compound.

The amount of the base polymer (A) used is preferably from 10 to 80% by mass based on the total amount of the component (A) and the component (B). In the case where the amount is 10% by mass or more, a thick film having a thickness of 50 µm or more can be easily produced upon forming a film, In the case where the amount is 80% by mass or less, on the other hand, the photocuring reaction can sufficiently proceed. Taking these factors into consideration, the amount of the base polymer (A) used is more preferably from 20 to 70% by mass.

The amount of the photopolymerizable compound (B) used is preferably from 20 to 90% by mass based on the total amount of the component (A) and the component (B). In the case where the amount is 20% by mass or more, the base polymer can be easily entwined therein and cured. In the case where the amount is 90% by mass or less, on the other hand, a film having a large thickness can be easily formed. Taking these factors into consideration, the amount of the photopolymerizable compound (B) used is more preferably from 30 to 80% by mass.

The amount of the photopolymerization initiator (C) used is preferably from 0.1 to 10 parts by mass per 100 parts by mass of the component (A) and the component (B). In the case where the amount is 0.1 parts by mass or more, sufficient optical sensitivity can be obtained. In the case where the amount is 10% by mass or less, absorption on the surface layer of the photosensitive resin composition is prevented from becoming too large in exposure, and photocuring of the interior thereof can proceed sufficiently. Furthermore, transmission loss due to light absorption of the photopolymerization initiator itself can be favorably prevented from becoming larger. Taking these factors into consideration, the amount of the photopolymerization initiator (C) used is more preferably from 0.2 to 5% by mass.

The optical waveguide film of the present invention can be easily produced by coating a resin composition containing the components (A) to (C) dissolved in a solvent on a substrate, followed by removing the solvent. The solvent used herein is not particularly limited as far as it can dissolve the resin composition, and examples thereof include such solvents as acetone, methyl ethyl ketone, methyl cellosolve, ethyl cellosolve, toluene, N,N-dimethylformamide, N,N-dimethylacetamide and propylene glycol monomethyl ether, and mixed solvents of them. The solid concentration in the resin solution is generally preferably approximately from 30 to 60% by mass.

The thickness of the optical waveguide film of the present invention is not particularly limited, and the thickness after drying is generally from 10 to 250 µm, In the case where the thickness is 10 µm or more, such an advantage is obtained that the coupling tolerance with a light receiving-emitting device and an optical fiber can be enhanced, and in the case where the thickness is 250 µm or less, such an advantage is obtained that the coupling efficiency with a light receiving-emitting device and an optical fiber can be improved. Taking these factors into consideration, the thickness of the film is more preferably in a range of from 40 to 90 µm.

The substrate used in the production process of the resin film for forming an optical waveguide in the present invention is a supporting substrate that supports the film for forming an optical waveguide, and is not particularly limited in material, and preferred examples thereof include polyester, such as polyethylene terephthalate, polypropylene and polyethylene since the film for forming an optical waveguide can be easily released therefrom later, and they have heat resistance and solvent resistance. The thickness of the substrate is preferably in a range of from 5 to 50 µm. In the case where the thickness is 5 µm or more, such an advantage is obtained that the strength as the supporting substrate can be easily obtained, and in the case where the thickness is 50 µm or less, such an advantage is obtained that the gap to the mask used in pattern formation can be decreased to facilitate formation of a finer pattern. Taking these factors into consideration, the thickness of the substrate is more preferably in a range of from 10 to 40 µm, and more preferably from 20 to 30 µm.
The film for forming an optical waveguide thus produced on the substrate can be easily stormed, for example, by winding in a roll form. Furthermore, a protective film may be provided on the film for forming an optical waveguide depending on necessity. The substrate and the protective film may be subjected to an antistatic treatment or the like for facilitating release of the film for forming an optical waveguide in a later stage.

A production method for forming an optical waveguide by using the resin film for forming an optical waveguide obtained in the aforementioned manner will be described. Examples of the method include a method, in which a lower clad film released from the substrate is laminated under pressure with heating onto a board after removing the protective film in the case where the protective film is present. The lamination is preferably performed under reduced pressure from the standpoint of adhesiveness and followability. The heating temperature of the resin film is preferably from 50 to 130°C, and the pressing pressure therefor is preferably approximately from 0.1 to 1.0 MPa (approximately from 1 to 10 kgf/cm²), although these conditions are not particularly limited.

The thickness of the lower clad layer is not particularly limited and is preferably from 2 to 50 µm, In the case where the thickness is 2 µm or more, transmitted light can be easily confined inside the core, and in the case where the thickness is 50 µm or less, the total thickness of the optical waveguide may not become too large. In the present invention, for satisfying bending durability under a particularly small bending radius, the thickness of the lower clad layer is more preferably in a range of from 2 to 20 µm, and particularly preferably in a range of from 5 to 15 µm.
The thickness of the lower clad layer herein is a value of from the interface between the core part and the lower clad layer to the lower surface of the lower clad layer.

Subsequently, the lower clad film is cured with light or heat, and a core film having a higher refractive index than the lower clad film is laminated in the similar manner. The resin film thus laminated is irradiated with active light imagewise through a negative or positive mask pattern, which is referred to as an art work. Examples of a light source of the active light include known light source capable of radiating effectively an ultraviolet ray, such as a carbon arc lamp, a mercury vapor arc lamp, a superhigh pressure mercury lamp, a high pressure mercury lamp and a xenon lamp. Furthermore, those capable of radiating effectively visible light, such as a photoflood lamp and a solar light lamp, may also be used.

The height of the core part 2 is not particularly limited and is preferably from 10 to 150 µm. In the case where the height of the core part is 10 µm or more, the alignment tolerance on coupling with a light receiving-emitting device or an optical fiber after forming the optical waveguide can be prevented from being reduced, and in the case where the height is 150 µm or less, the coupling efficiency can be prevented from being reduced on coupling with a light receiving-emitting device or an optical fiber after forming the optical waveguide. In the present invention, for satisfying bending durability under a particularly small bending radius, the height of the core part is preferably in a range of from 30 to 120 µm, and particularly preferably in a range of from 50 to 90 µm.

Subsequently, after exposure, the non-exposed part is removed through development by wet development, dry development or the like, thereby producing the core pattern. In the case of the wet development, the development is performed by using a developing liquid corresponding to the composition of the resin film, such as an organic solvent, an alkaline aqueous solution or an aqueous developing liquid, by a known method, such as spraying, immersion under oscillation, brushing and scraping.
The developing liquid used is preferably ones that are safe and stable and are excellent in handleability, such as an organic solvent and an alkaline aqueous solution. Examples of the organic solvent developing liquid include 1,1,1-trichloroethane, N-methylpyrrolidone, N,N-dimethylformamide, N,N-dimethylacetamide, cyclohexanone, methyl isobutyl ketone and γ-butyrolactone. The organic solvent may contain water added in a range of from 1 to 20% by mass for preventing ignition.

Examples of the base used in the alkaline aqueous solution include an alkalihydroxide, such as hydroxides of lithium, sodium and potassium, a carbonate alkali, such as carbonates and bicarbonates of lithium, sodium, potassium and ammonium, an alkali metal phosphate, such as potassium phosphate and sodium phosphate, and an alkali metal pyrophosphate, such as sodium pyrophosphate and potassium pyrophosphate. Preferred examples of the alkaline aqueous solution used for development include a 0.1 to 5% by mass diluted solution of sodium carbonate, a 0.1 to 5% by mass diluted solution of potassium carbonate, a 0.1 to 5% by mass diluted solution of sodium hydroxide, and a 0.1 to 5% by mass diluted solution of sodium tetraborate. The alkaline aqueous solution used for development preferably has pH in a range of from 9 to 14, and the temperature thereof is controlled depending on the developing property of the layer of the photosensitive resin composition. The alkali aqueous solution may contain a surfactant, a defoaming agent and a small amount of an organic solvent for accelerating development.

The aqueous developing liquid may contain water or an alkali aqueous solution and at least one organic solvent. Examples of the alkaline substance include, in addition to the aforementioned substances, borax, sodium metasilicate, tetramethylammonium hydroxide, ethanolamine, ethylenediamine, diethylenetriamine, 2-mini-2-hydraxymethyl-1,3-propanediol, 1,3-diaminopropanol-2-morpholine. The pH of the developing liquid is preferably as small as possible within a range capable of developing the resist sufficiently, and is preferably pH 8 to 12, and more preferably pH 9 to 10. Examples of the organic solvent include triacetone alcohol, acetone, ethyl acetate, alkoxyethanol having an alkoxy group having from 1 to 4 carbon atoms, ethyl alcohol, isopropyl alcohol, butyl alcohol, diethylene glycol monomethyl ether, diethylene glycol monoethyl ether and diethylene glycol monobutyl ether. These may be used solely or in combination of two or more of them. The concentration of the organic solvent is generally preferably from 2 to 90% by mass, and the temperature thereof can be controlled depending on the developing property. The aqueous developing liquid may contain a surfactant, a defoaming agent and the like added in a small amount.

Furthermore, two or more kinds of the developing methods may be used in combination depending on necessity. Examples of the developing method include a dipping method, a battle method, a spray method, such as a high pressure spray method, brushing and scraping.
As a treatment after the development, the core pattern may further be cured by heating to from 60 to 250°C or by exposing to from 0.1 to 1,000 mJ/cm².

Subsequently, an upper clad film having a lower refractive index than that of the core film is laminated thereon in the similar manner to produce an optical waveguide. The thickness of the upper clad layer is not particularly limited as far as it is in a range capable of embedding the core part, and is preferably from 2 to 50 µm after drying, For satisfying bending durability under a particularly small bending radius, the thickness is more Preferably in a range of from 2 to 20 µm, and particularly preferably in a range of from 5 to 15 µm. The thickness of the upper clad layer may be the same as or different from a thickness of the lower clad layer formed at the beginning. The thickness of the upper clad layer herein is a value from the boundary between the core part and the upper clad layer to the upper face of the upper clad layer.

### Flexible Electric Circuit Board

An FPC (flexible printed circuit) board can suitably be used as the flexible electric circuit board. The material for the FPC board may be polyimide, polyamide, polyetherimide, polyethylene terephthalate, a liquid crystal polymer and the like, and polyimide may be used from the standpoint of heat resistance and availability. Examples of a commercially available product thereof include an FPC board formed of Kapton (produced by Du Pont-Toray Co., Ltd.).
While thickness of the board constituting the flexible electric circuit board is not particularly limited, the ratio in thickness of the reinforcing member and the board is preferably in a range of from 4/1 to 1/4 from the standpoint of bending durability as having been described above, and thus the thickness of the board is preferably selected to satisfy the range. The thickness of the board is also determined appropriately in consideration of the thickness that is demanded by the opto-electric hybrid board itself, and the thickness is preferably in a range of from 5 to 50 µm, more preferably in a range of from 5 to 25 µm, and particularly preferably in a range of from 5 to 15 µm.

### Opto-electric hybrid Board

The opto-electric hybrid board of the present invention is produced by bonding the optical waveguide film and the flexible electric circuit board described above.
Upon bonding the optical waveguide film and the flexible electric circuit board, an adhesive may be used depending on necessity. The kind of the adhesive can suitably be selected according to the materials of the optical waveguide film and the flexible electric circuit board.
The adhesive preferably has flexibility after curing in order to provide the opto-electric hybrid board with flexibility, and specifically, the adhesive preferably has an elastic modulus of 700 MPa or less, more preferably 600 MPa or less, and particularly preferably 500 MPa or less, after curing. The elastic modulus is preferably 1 MPa or more, and more preferably 5 MPa or more, from the standpoint of the strength of the adhesive.
Preferred examples of the kind of the adhesive include an acryl rubber base adhesive and, as a commercially available product, a high heat resistant adhesive insulating material KS7003 (elastic modulus: 700 MPa), produced by Hitachi Chemical Co., Ltd., an adhesive for a flexible printed circuit board Hi-Bon 808 (elastic modules: 50 MPa), produced by Hitachi Kasei polymer Co., Ltd. and the like.

The bonding method of the optical waveguide film and the flexible electric circuit board is not particularly limited, and such methods are preferred as a method using a roll laminator and a method using a flat plate laminator from the standpoint of the adhesion property and prevention of entrainment of air bubbles. The lamination temperature of the roll laminator is preferably in a range of from room temperature (25°C) to 100°C. In the case where the temperature is room temperature (25°C) or more, the adhesive property to the optical waveguide is enhanced, and in the case where the temperature is 100°C or less, on the other hand, the adhesive layer is prevented from flowing, thereby providing the required thickness. Taking these factors into consideration, the temperature is more preferably in a range of from 40 to 100°C. The pressure is preferably from 0.2 to 1.0 MPa (from 1 to 10 kgf/cm²), and the lamination speed is preferably from 0.1 to 3 m/min. However, these conditions are not particularly limited.
The flat plate laminator herein means a laminator, in which materials to be laminated are held between a pair of flat plates and press-adhered by applying pressure to the flat plates, and a vacuum pressure laminator can be preferably used. The heating temperature thereon is preferably from 50 to 100°C, and the pressing pressure is preferably from 0.1 to 1.0 MPa (from 1 to 10 kgf/cm²). However, these conditions are not particularly limited.

The reinforcing member, which is one of the features of the present invention, is attached to the opto-electric hybrid board thus produced in the aforementioned manner. The method for attaching the reinforcing member is not particularly limited, and a method using an adhesive may be conveniently employed. Examples of the adhesive used herein include the same ones as being used for bonding the optical waveguide film and the flexible electric circuit board.

### EXAMPLES

The present invention will be described in more detail with reference to examples below, but the present invention is not restricted in any way by the examples.

### Evaluation Methods

### 1. Tensile Elastic Modulus and Tensile Strength

A specimen having a width of 10 mm and a length of 70 mm was obtained from the film to be measured, and was measured according to JIS K7127 under the following conditions with a tensile tester (RTM-100, produced by Orientec Co., Ltd.).
Conditions: distance between chucks: 50 mm; temperature: 25°C; tensile speed: 50 mm/min
The tensile elastic modulus was calculated by the following expression from the initial straight line part of the tensile stress-distortion curve. The maximum strength until breakage in the tensile stress-distortion curve was designated as the tensile strength.
Tensile elastic modulus (MPa) = (difference (N) in stress between two points on the straight line) / (original average cross-sectional area (mm²) of optical waveguide film) / (difference in distortion between the two points)

### 2. Bending Durability Test

The opto-electric hybrid boards produced in Examples and Comparative Examples were subjected to a bending durability test under the conditions of a bending angle of from 0 to 180° a bending radius of 1.5 mm and a bending speed of 2 per second with a bending durability tester produced by Daisho Denshi Co., Ltd.), and the presence of breakage was observed every 100,000 times bending, thereby measuring the maximum number of bending until breakage.
The bending durability test used for evaluating the transmission loss of light and the appearance of the core described below was performed for two or more specimens with a time difference therehetween, and the number of bending that was smaller by 10% than the number of bending when the specimen having been subjected to the test most precedently was broken was designated as the number immediately before breakage.

### 3. Transmission Loss of Light

The opto-electric hybrid boards produced in Examples and Comparative Examples were measured for transmission loss before bending and transmission loss after bending in the number immediately before breakage in the bending durability test, and the transmission loss of light was evaluated by the difference therebetween. The transmission loss of light was measured with a plane emission laser of 850 nm (FLS-300-01-VCL, produced by EXFO, Inc.) as a light source and Q82214, produced by Advantest Corporation, was used as a light receiving sensor, under the conditions of a measured waveguide length of 10 cm, GI-50/125 multimode fiber (NA = 0.20) as an incoming fiber, and SI-114/125 (NA = 0.22) as an emission fiber.

### 4. Appearance of Core

The opto-electric hybrid boards produced in Examples and Comparative Examples were visually evaluated for appearance of the core after bending in the number immediately before breakage in the bending durability test. The evaluation standard was as follows.
A: The appearance was favorable.
B: Minute cracks were formed, but it was such an extent that light was transmitted (the increment of light transmission loss after the light transmission loss test was 1 dB or more and less than 10 dB).
C: Large cracks inducing breakage were formed.

### Example 1

### (1-1) Production of Optical Waveguide Film Production of Resin Film for forming Clad Layer

48 parts by mass of a phenoxy resin (Phenotohto YP-70, a trade name, produced by Tohto Kasei Co., Ltd.) as the binder polymer (A), 49.6 parts by mass of an alicyclic diepoxycarboxylate (KRM-2110, a trade name, produced by Asahi Denka Co., Ltd., molecular weight: 252) as the photopolymerizable compound (B), 2 parts by mass of a triphenylsulfonium hexafluoroantimonate salt (SP-170, a trade name, produced by Asahi Denka Co., Ltd.) as the photopolymerization initiator (C), 0.4 part by mass of SP-100 (a trade name, produced by Asahi Denka Go., Ltd.) as a sensitizer and 40 parts by mass of propylene glycol monomethyl ether acetate as an organic solvent were weighed in a wide mouthed resin bottle, and were stirred for 6 hours under the conditions of a temperature of 25°C and a revolution number of 400 rpm with a mechanical stirrer, a shaft and a propeller, thereby preparing a resin vanish A for forming a clad layer. Thereafter, the resin vanish was filtrated under pressure through Polyflon Filter (a trade name, PFQ20, produced by Advantech Toyo Co., Ltd.) having a pore diameter of 2 µm under the conditions of a temperature of 25°C and a pressure of 0.4 MPa, and was further defoamed under reduced pressure for 15 minutes with a vacuum pump and a bell jar under the condition of a vacuum degree of 50 mm Hg.

The resin vanish A for forming a clad layer thus obtained was coated on a corona-treated surface of a polyamide film (Mictron, a trade name, produced by Tory Industries, Inc., thickness: 12 µm) with a coating machine (Multicoater TM-MC, produced by Hirano Tecseed Co., Ltd.), and was dried at 80°C for 10 minutes and then at 100°C for 10 minutes. A releasable PET film (Purex A31, a trade name, produced by Teijin DuPont Films Japan Ltd., thickness; 25 µm) as a protective film was attached thereon with the releasable surface facing the resin side, thereby preparing a resin film for forming a clad layer. The thickness of the resin layer may be arbitrarily controlled by controlling the gap of the coating machine. In this example, the gap was controlled to make the film thicknesses after curing of 20 µm for the lower clad layer and 70 µm for the upper clad layer.

### Production of Resin Film for forming Core Layer

A resin vanish B for forming a core layer was prepared in the same manner under the same conditions as in the production example of the resin film for forming a clad layer described above, except that 26 parts by mass of a phenoxy resin (Phenotohto YP-70, a trade name, produced by Tohto Kasei Co., Ltd.) as the binder polymer (A), 36 parts by mass of 9,9-bis(4-(2-acryloyloxyethoxy)phenyl)fluorene (A-BPEF, a trade name, produced by Shin-Nakamura Chemical Co., Ltd.) and 36 parts by mass of a bisphenol A type epoxy acrylate (EA-1020, a trade name, produced by Shin-Nakamura Chemical Co., Ltd.) as the photopolymerizable compound (B), 1 part by mass of bis(2,4,6-trimethylbenzoyl)phenylphosphine oxide (Irgacure 819, a trade name, produced by Ciba Specialty Chemicals Co., Ltd.) and 1 part by mass of 1-(4-(2-hydroxyethoxy)phenyl)-2-hydroxy-2-methyl-1-propan-1-one (Irgacure 2959, a trade name, produced by ciba Specialty Chemicals Co., Ltd.) as the photopolymerization initiator (C) and 40 parts by mass of propylene glycol monomethyl ether acetate as the organic solvent. Thereafter, the resin vanish was filtrated under pressure and further defoamed under reduced pressure in the same manner under the same conditions as in the production example described above.
The resin vanish B for forming a core layer obtained above was coated on a non-treated surface of a PET film (COSMO SHINE A1517, a trade name, produced by Toyobo Co., Ltd., thickness: 16 µm) and dried in the same manner as in the production example described above. A releasable PET film (Purex A31, a trade name, produced by Teijin DuPont Films Japan Ltd., thickness: 25 µm) as a protective film was attached thereon with the releasable surface facing the resin side, thereby preparing a resin film for forming a core layer. In this example, the gap of the coating machine was controlled to make the film thickness after curing of 50 µm.

### Production of Optical Waveguide Film

The releasable PET film (Purex A31) as the protective film of the resin film for forming a lower clad layer obtained above was peeled off, and the resin film was irradiated with an ultraviolet ray (wavelength: 365 nm) at 1 J/cm² from the resin side (the opposite side to the substrate film) with an ultraviolet ray exposing machine (EXM-1172, produced by Orc Manufacturing Co., Lid.), and then heat-treated at 80°C for 10 minutes, thereby producing a lower clad layer.

The resin film for forming a core layer described above was then laminated on the lower clad layer under the conditions of a pressure of 0.4 MPa, a temperature of 50°C and a laminating speed of 0.2 m/min with a roll laminator (HLM-1500, produced by Hitachi Plant Techno Co., Ltd.), and then the assembly was depressurized to 500 Pa or lower, and was pressed with heating under the conditions of a pressure of 0.4 MPa, a temperature of 50°C and a pressing time of 30 seconds, with a vacuum press laminator (MVLP-500, produced by Meiki Co., Ltd.) as a flat plate type laminator, thereby forming a core layer.

The core layer was irradiated with an ultraviolet ray (wavelength: 365 nm) at 0.6 J/cm² with the UV ray exposing machine described above through a negative type photomask having a width of 50 µm and then heated to 80°C for 5 minutes after exposure. Thereafter, the PET film as the supporting film was peeled off, and the core pattern was developed with a developer liquid (propylene glycol monomethyl ether acetate/N,N-dimethylacetamide = 8/2, mass ratio) . Subsequently, the core layer was rinsed with a rinsing liquid (isopropanol) and dried by heating to 100°C for 10 minutes.

The resin film for forming a clad layer described above was then laminated thereon as an upper clad layer under the same laminating conditions as described above. Furthermore, both surfaces thereof were irradiated with an ultraviolet ray (wavelength: 365 nm) at 25 J/cm² in total, and then the resin film was heat-treated at 160°C for 1 hour, thereby producing an upper clad layer, whereby a flexible optical waveguide having the substrate film disposed outside was produced. The flexible optical waveguide was treated under a high temperature and high humidity condition of 85°C/85% for 24 hours for peeling the polyamide film off, thereby producing an optical waveguide, from which the substrate film had been removed.

The core layer and the clad layer were measured for refractive index with a prism coupler (Model 2010), produced by Metricon Inc., and the refractive index was 1.584 for the core layer and 1.550 for the clad layer at a wavelength of 830 nm. The propagation loss of the optical waveguide thus prepared was measured by a cutback method (measured waveguide lengths: 10, 5, 3 and 2 cm, incoming fiber: GI-50/125 multimode fiber (NA = 0.20), emission fiber: SI-114/125 (NA = 0.22)) using a plane emission laser of 850 nm (FLS-300-01-VCL, produced by EXFO Inc.) as a light source and Q82214, produced by Advantest Corporation, as a receiving sensor, and the propagation loss was 0.05 dB/cm.
The tensile elastic modulus and the tensile strength of the optical waveguide film obtained were measured by the methods described above. The tensile elastic modulus was 2,000 MPa, and the tensile strength was 70 MPa.

### (1-2) Production of Sheet Adhesive

100 parts by mass of HTR-860P-3 (a trade name, produced by Teikoku Chemical Industry Co., Ltd., glycidyl group-containing acryl rubber, molecular weight: 1,000,000, Tg: -7°C), 5.4 parts by mass of YDCN-703 (a trade name, produced by Tohto Kasei Co., Ltd., o-cresol novolak type epoxy resin, epoxy equivalent: 210), 16.2 parts by mass of YDCN-8170C (a trade name, produced by Tohto Kasei Co., Ltd., bisphenol F type epoxy resin, epoxy equivalent: 157), 15.3 parts by mass of Plyophen LF2882 (a trade name, produced by Dainippon Ink & Chemicals Inc., bisphenol A novolak resin), 0.1 part by mass of NUCA-189 (a trade name, produced by Nippon Unicar Co., Ltd., γ-mercaptopropyltrimethoxysilane), 0.3 part by mass of NUCA-1160 (a trade name, produced by Nippon Unicar Co. Ltd., γ-ureidopropyltriethoxysilane), parts by mass of A-DPH (a trade name, produced by Shin-Nakamura Chemical Co. , Ltd. , dipentaerythritol hexaacrylate), 1.5 part by mass of Irgacure 369 (a trade name, 2-benzyl-2-dimethylamino-1-(4-morpholinophenyl)butanon-l-one, I-369, produced by Ciba Specialty chemicals Co., Ltd.) and cyclohexanone were mixed under stirring, and the mixture was deaerated under vacuum. The adhesive vanish thus obtained was coated on a surface release-treated polyethylene terephthalate having a thickness of 75 µm (Teijin Tetron film A-31, produced by Teijin Limited), and dried by heating to 80°C for 30 minutes, thereby preparing- a tacky adhesive sheet. A light transmitting supporting substate having a thickness of 80 µm (FHF-100, produced by Thermo Co., Ltd., a three-layer film of low density polyethylene terephthalate/vinyl acetate/low density polyethylene terephthalate) was laminated on the tacky adhesive sheet, thereby preparing a sheet adhesive containing the protective film (surface release-treated polyethylene terephthalate), the tacky adhesive layer and the light transmitting supporting substrate. The thickness of the tacky adhesive layer was 10 µm.

The tacky adhesive layer of the sheet adhesive thus prepared was cured at 160°C for 1 hour, and the light transmittance thereof was measured with U-3310 ultraviolet/visible ray spectrophotometer, produced by Hitachi High-Technologies Corporation. As a result, a high transmittance of 98% or more at a wavelength of 850 nm was obtained, and the transmission loss was equivalent to 0.1 dB or less.
The refractive index was measured with a prism coupler (Model 2010), produced by Metricon Inc., and the refractive index was 1.505 at a wavelength of 830 nm.
The tensile elastic modulus of the sheet adhesive thus obtained was measured by the method described above, and the tensile elastic modulus was 350 MPa.

### (1-3) Production of Opto-electric hybrid Board

The sheet adhesive, from which the protective film had been peeled off, was laminated on the flexible optical waveguide under the conditions of a pressure of 0.4 MPa, a temperature of 50°C and a laminating speed of 0.2 m/min with a roll laminator (HLM-1500, produced by Hitachi Chemical Techno Plant Co., Lid.). Subsequently, the waveguide was cut into a strip form (length: 120 mm, width: 2 mm) with a dicing saw (DAD-341, produced by DISCO Corporation) and irradiated with an ultraviolet ray (365 nm) from the side of the supporting substrate to decrease the adhesive strength between the tacky adhesive layer and the supporting substrate, followed by peeling the supporting substrate, thereby providing an optical waveguide having an adhesive layer.
The optical waveguide having an adhesive layer was aligned to the prescribed position of a flexible electric circuit board having electric wiring (length: 120 mm, width: 2 mm, substrate: Kapton 100EN (having a tensile strength of 370 MPa measured by the method described above), thickness: 25 µm, copper circuit thickness: 12 µm) by utilizing the mask aligner mechanism of an ultraviolet ray exposing equipment (MAP-1200-L, produced by Dainippon Screen Mfg. Co., Ltd.), and the optical waveguide was temporarily adhered thereon by pressing under the conditions of a pressure of 0.4 MPa, a temperature of 80°C and a laminating speed of 0.2 m/minute with the roll laminator, and then heated in a clean oven to 160°C for hour to adhere the flexible optical waveguide to the electric circuit board, thereby producing an opto-electric hybrid board.
The light transmittance of Kapton EN as the substrate of the flexible electric circuit board was measured with a spectrophotometer U-3310, produced by Hitachi High-Technologies Corporation, and the light transmittance was 86% at a wavelength of 850 nm. The value was equivalent to a transmission loss corresponding to 0.7 dB, and the optical loss through the electric circuit board derived from the total transmission loss of the substrate and the tacky adhesive layer was as low as less than 1 dB. Accordingly, a structure having no through-hole for light transmission provided was employed in this example.

Subsequently, as shown in Fig. 4, a reinforcing member was provided to cover the part Y¹ on the side of the optical waveguide film at the point X¹ where the opto-electric hybrid board was in contact with the hinge part (bend starting point). The reinforcing member used was a polyimide resin film (Kapton 50EN, produced by Du Pont-Toray Co., Ltd., thickness: 12.5 µm, tensile strength: 380 MPa) having a length of 30 mm and a width of 2 mm, which was the same as the electric circuit board. The results of evaluation in the manner described above are shown in Table 1.

### Example 2

An opto-electric hybrid board was produced in the same manner as in Example 1 except that a flexible electric circuit board having a thickness of 12.5 µm (length: 120 mm, width: 2 mm) and having a substrate of Kapton 50EN (tensile strength: 380 MPa, copper circuit thickness; 12 *µ*m) was used. The results of evaluation in the same manner as in Example 1 are shown in Table 1.

### Example 3

An opto-electric hybrid board was produced in the same manner as in Example 2 except that the thickness of the reinforcing member was changed to 25 µm (Kapton 100EN, produced by Du Pont-Toray Co., Ltd., tensile strength: 370 MPa). The results of evaluation in the same manner as in Example 1 are shown in Table 1.

### Example 4

An opto-electric hybrid board was produced in the same manner as in Example 2 except that an aramid resin film (Mictron ML, produced by Du Pont-Toray Co., Ltd., thickness: 25 µm, tensile strength: 600 MPa) was used as the reinforcing member. The results of evaluation in the same manner as in Example 1 are shown in Table 1.

### Example 5

An opto-electric hybrid board was produced in the same manner as in Example 4 except that an aramid resin film having a thickness of 12.5 µm (Mictron ML, produced by Du Pont-Toray Co., Ltd., tensile strength: 600 MPa) was used as the reinforcing member. The results of evaluation in the same manner as in Example 1 are shown in Table 1.

### Comparative Example 1

An opto-electric hybrid board was produced in the same manner as in Example 1 except that the reinforcing member was not provided. The results of evaluation in the same manner as in Example 1 are shown in Table 1.

**Table 1**

| | | Example 1 | Example 2 | Example 3 | Example 4 | Example 5 | Comparative Example 1 |
|---|---|---|---|---|---|---|---|
| Flexible electric circuit board | Material | polyimide | polyimide | polyimide | polyimide | polyimide | polyimide |
| | Thickness (µm) | 25 | 12.5 | 12.5 | 12.5 | 12.5 | 25 |
| | Tensile strength (MPa) | 370 | 380 | 380 | 380 | 380 | 370 |
| Optical waveguide film | Tensile elastic modulus (MPa) | 2000 | 2000 | 2000 | 2000 | 2000 | 2000 |
| | Tensile strength (MPa) | 70 | 70 | 70 | 70 | 70 | 70 |
| Reinforcing material | Material | polyimide | polyimide | polymide | aramid | aramid | none |
| | Thickness (µm) | 12,5 | 12.5 | 25 | 25 | 12.5 | - |
| | Tensile strength (MPa) | 380 | 380 | 370 | 600 | 600 | - |
| Ratio in tensile strength of reinforcing material and optical waveguide film (reinforcing material/optical waveguide film) | | 5.4 | 5.4 | 5.2 | 8.6 | 8.6 | - |
| Ratio in thickness of reinforcing material and substrate | | 1/2 | 1/1 | 2/1 | 2/1 | 1/1 | - |
| Evaluation results | Bending duragility test (times) | 700,000 | 1,000,000 | 1,500,000 | 2,000,000 | 2,500,000 | 3,000 |
| | Transmission loss of light (dB) | 2.5 | 0.2 | 1.5 | 3 | 1.5 | 40 |
| | Appearance of core | B | A | B | B | B | C |

As shown in Table 1, it is understood that the opto-electric hybrid board is significantly enhanced in bending durability only by providing a reinforcing material on at least a part on the side of the optical waveguide film where the opto-electric hybrid board is in contact with the hinge, particularly on the bend starting point.

### INDUSTRIAL APPLICABILITY

The opto-electric hybrid board of the present invention has such excellent bending durability that the optical waveguide film part does not suffer breakage and cracking even when the circuit board is repeatedly bent over a prolonged period of time. Accordingly, the opto-electric hybrid board of the present invention can suitably be used for an electronic device, such as a mobile phone, and can maintain favorable communication function for a prolonged period of time even in the case where the circuit board is demanded to be bent at a hinge part with a small bending radius R of approximately from 1.5 to 2 mm, thereby achieving high reliability and durability of the electronic device itself.

## Claims

1. A flexible opto-electric hybrid board comprising an optical waveguide film containing a core and a clad, and a flexible electric circuit board bonded to each other, the flexible opto-electric circuit board further having a reinforcing member disposed on at least a part on a side of the optical waveguide film to be bent.

2. The flexible opto-electric hybrid board according to claim 1, wherein the reinforcing member reinforces the side of the optical waveguide film at a bend starting point of the flexible opto-electric hybrid board.

3. The flexible opto-electric hybrid board according to claim 1 or 2, wherein a ratio of a thickness of the reinforcing member and a thickness of a substrate constituting the flexible electric circuit board is from 4/1 to 1/4.

4. The flexible opto-electric hybrid board according to any one of claims 1 to 3, wherein the reinforcing member has a tensile strength that is larger than that of the optical waveguide, film,

5. The flexible opto-electric hybrid board according to any one of claims 1 to 4, wherein the reinforcing member contains at least one member selected from the group consisting of a polyimide resin, an aramid resin, a glass fiber-reinforced resin and a carbon fiber-reinforced resin.

6. The flexible opto-electric hybrid board according to any one of claims 1 to 5, wherein the reinforcing member has a thickness of from 4 to 50 µm.

7. An electronic device comprising a opto-electric hybrid board comprising an optical waveguide film containing a core and a clad, and a flexible electric circuit board bonded to each other, and a hinge for bending the opto-electric hybrid board, the electronic device having such a structure that a part of the opto-electric hybrid board is movable in a rotation direction with the hinge as center, and further having a reinforcing member disposed on at least a part on a side of the optical waveguide film where the opto-electric hybrid board is in contact with the hinge.

8. An electronic device comprising a opto-electric hybrid board comprising an optical waveguide film containing a core and a clad, and a flexible electric circuit board bonded to each other, the electronic device having such a structure that at least one end part of the opto-electric hybrid board is moved in a horizontal direction while maintaining a bent state of the opto-electric hybrid board with a bent part as canter, and the bent part is also moved associated with the movement of the end part, the opto-electric hybrid board having a reinforcing member disposed on at least a part on a side of the optical waveguide film at the bent part.

9. The electronic device according to claim 7 or 8, wherein the reinforcing member reinforces the side of the optical waveguide film at a bend starting point of the flexible opto-electric hybrid board.

10. The electronic device according to any one of claims 7 to 9, wherein a ratio of a thickness of the reinforcing member and a thickness of a substrate constituting the flexible electric circuit board is from 4/1 to 1/4.

11. The electronic device according to any one of claims 7 to 10, wherein the reinforcing member has a tensile strength that is larger than that of the optical waveguide film.

12. The electronic device according to any one of claims 7 to 11, wherein the reinforcing member contains at least one member selected from the group consisting of a polyimide resin, an aramid resin, a glass fiber-reinforced resin and a carbon fiber-reinforced resin.

13. The electronic device according to any one of claims 7 to 12, wherein the reinforcing member has a thickness of from 4 to 50 µm.
